Europäisches Patentamt

European Patent Office

Office européen des brevets

(19)

(11) **EP 1 107 640 A2**

(12) **EUROPÄISCHE PATENTANMELDUNG**

(43) Veröffentlichungstag:
**13.06.2001 Patentblatt 2001/24**

(51) Int Cl.[7]: **H04R 3/04**

(21) Anmeldenummer: **00123848.4**

(22) Anmeldetag: **02.11.2000**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **18.11.1999 DE 19955696**

(71) Anmelder: **Micronas GmbH**
**79108 Freiburg (DE)**

(72) Erfinder: **Vierthaler, Matthiad**
**79108 Freiburg (DE)**

(74) Vertreter: **Patentanwälte**
**Westphal, Mussgnug & Partner**
**Waldstrasse 33**
**78048 Villingen-Schwenningen (DE)**

(54) **Vorrichtung zur Erzeugung von Oberwellen in einem Audiosignal**

(57) Vorrichtung zur Erzeugung von Oberwellen in einem Audiosignal mit einer Addierstufe, durch welche Signale einer ersten Signalstrecke und einer zweiten Signalstrecke addierbar wird, wobei am Ausgang der Addierstufe ein oberwellenbehaftetes Audiosignal abprüfbar und in der zweiten Signalstrecke eine Filtereinrichtrung und eine nichtlineare Schaltungeinrichtung angeordnet ist, wobei eine Eckfrequenz der Filtereinrichtung einstellbar ist.

Fig.1

**Beschreibung**

Die Erfindung betrifft eine Vorrichtung zur Erzeugung von Oberwellen in einem Audiosignal gemäß den Merkmalen des Oberbegriffs des Anspruchs 1.

Derartige Verfahren und Schaltungsvorrichtungen werden in Geräten zur akustischen Wiedergabe eingesetzt, wie z. B. Fernsehgeräte, Rundfunkempfänger oder Stereoanlagen, um den Frequenzgang der Lautsprecher zu kompensieren, die akustische Wiedergabe zu verbessern, sowie eine Übersteuerung des Gerätes bzw. der Anlage zu verhindern.

Das am meisten kritische Glied in einem Gerät zur akustischen Wiedergabe ist der Lautsprecher, dessen Schalldruck unterhalb einer baubedingten Grenzfrequenz mit etwa 40 db pro Dekade abfällt, was der Übertragungsfunktion eines Filters zweiter Ordnung entspricht. Baßreflex- und Transmissionline-Lautsprecher haben dagegen Übertragungsfunktionen, die einem Filter höherer Ordnung entsprechen. Die untere Grenzfrequenz liegt typischerweise zwischen etwa 50 Hz und 200 Hz. Je tiefer die Grenzfrequenz eines Lautsprechers ausfällt, desto teurer wird seine Herstellung. Preisgünstige Geräte wie z. B. Fernseher oder tragbare Rundfunkempfänger sind daher mit einfacheren Lautsprechern ausgerüstet, deren untere Grenzfrequenz verhältnismäßig hoch liegt. Um die akustische Wiedergabe im unteren Frequenzbereich zu verbessern, wird die Grenzfrequenz durch Vorverstärkung der tiefen Frequenzen nach unten verschoben, was jedoch zu einer Übersteuerung des Endverstärkers und der Lautsprecher führen kann. Um eine Übersteuerung und möglicherweise dadurch sogar bedingte Zerstörung der Endverstärker oder der Lautsprecher zu verhindern, wird das Ausgangssignal des Baßverstärkers derart rückgekoppelt, daß bei großem Ausgangssignal die Verstärkung der tieferen Frequenzen verringert wird. Ein derartiges Verfahren ist aus der US-PS 5,305,388 bekannt.

In der US-PS 5,359,665 ist eine Schaltungsanordnung beschrieben, in der das Audiosignal unmittelbar über einen ersten Pfad dem ersten Eingang eines Addierers zugeführt wird, während es gleichzeitig über einen zweiten Pfad über einen Tiefpaß und einen Verstärker mit variabler Verstärkung dem zweiten Eingang des Addierers zugeführt wird. Der Ausgang des Verstärkers ist über einen Signalpegeldetektor auf seinen Steuereingang rückgekoppelt. Durch diese Maßnahme wird eine Übersteuerung der Endverstärker verringert.

Aus der Psychoakustik ist es bekannt, daß ein Mensch die Grundtonhöhe eines Tones auch dann noch eindeutig bestimmen kann, wenn die Grundfrequenz im Spektrum überhaupt nicht vorhanden ist, sondern nur noch Harmonische der Grundfrequenz. Diesen psychoakustischen Effekt macht man sich zu Nutze, indem die Harmonische der Grundfrequenz erzeugt und einem Lautsprecher zugeführt wird, dessen Grenzfrequenz oberhalb dieser Grundfrequenz liegt. Ein Hörer glaubt daher, diese tiefe Grundfrequenz zu hören, obwohl sie der Lautsprecher überhaupt nicht abstrahlt. Ein Hörer meint z. B. einen Ton mit 50 Hz zu hören, wenn der Lautsprecher zwar diesen tiefen Ton gar nicht überträgt, sondern lediglich einen Ton mit 250 Hz und einen Ton mit 300 Hz. Die Differenz von 50 Hz wird subjektiv vom Hörer wahrgenommen.

Diesen Effekt macht man sich zu nutze, wenn qualitativ einfache Lautsprecher mit hoher unterer Grenzfrequenz von z. B. 120 Hz tiefere Töne, z. B. ein Signal mit 60 Hz, übertragen sollen. Es werden dann aus dem 60 Hz-Signal Oberwellen, deren Differenz zueinander 60 Hz beträgt, erzeugt. Der Zuhörer meint dann tatsächlich einen Ton von 60 Hz zu hören, wenngleich dieser vom Lautsprecher gar nicht abgestrahlt wird.

Zur Erzeugung der Oberwellen sind elektronische Schaltungen notwendig, um einerseits die Grundfrequenz in einem Audiosignalgemisch zu bestimmen und zu extrahieren sowie Oberwellen dieser Grundfrequenz zu erzeugen.

Die US 5,668,885 und US 5,771,296 beschreiben die Erzeugung von Harmonischen, d. h. Oberwellen durch Absolutwertbildung mittels einer Gleichrichteranordnung.

Die US 4,150,253 und US 4,700,390 beschreiben die Erzeugung von Harmonischen durch Clipping, d. h. Abschneiden der Amplitude der Grundfrequenz des Audiosignales oberhalb eines bestimmten Wertes.

In allen diesen Dokumenten werden Filter mit festen Eckfrequenzen zur Selektion der Signale eingesetzt, von denen Oberwellen erzeugt werden sollen.

Nachteilig hierbei ist folgendes. Befindet sich mehr als ein Signal im selektierten Frequenzbereich und das ist bei realen Audiosignalen, die sich aus einem Frequenzspektrum zusammensetzen der Fall, werden nicht nur die Oberwellen der vorhandenen Signale erzeugt, sondern immer auch Oberwellen mit unerwünschter Frequenz, die aus der Summe aller vorhandenen Signalfrequenzen und deren Vielfachen bestehen. Dies führt dazu, dass der vom Lautsprecher letztlich abgestrahlte Ton sehr unsauber klingt.

Hier setzt die vorliegende Erfindung an.

Ziel der Erfindung ist es, eine Schaltungsanordnung anzugeben, mit der bei einem Hörer ein verbesserter Höreindruck beim Hören eines Audiosignales entsteht, das von Lautspechern mit verhältnismäßig hoher unterer Eckfrequenz abgestrahlt wird.

Diese Aufgabe wird durch eine Schaltungsanordnung mit den Merkmalen des Anspruchs 1 oder des Anspruchs 2 gelöst.

Vorzugsweise werden beide Schaltungsanordnungen miteinander kombiniert eingesetzt.

Die erste Lösung besteht erfindungsgemäß darin, diejenige Signalfrequenz, dessen Oberwellen erzeugt werden sollen, durch ein variables Filter, insbesondere ein Bandpassfilter, möglichst genau einzugrenzen.

Die zweite Lösung besteht darin, die Oberwellen mit einer Methode zu erzeugen, die wesentlich weniger ungewollte Frequenzen produziert als beim Stand der Technik. Dies wird durch Verwendung der n'ten Potenz des Eingangssignals erreicht. Durch diese kann die (n-1)-te Oberwelle erzeugt werden. n ist erfindungsgemäß größer gleich 2 zu wählen. Bei n = 2, also beim Quadrieren der Grundfrequenz des Eingangssignales, wird die erste Oberwelle erzeugt. Mit Grundfrequenz ist dabei die im Audiosignal enthaltene, dominierende Frequenz in einem Frequenzbereich von z. B. kleiner 120 Hz bezeichnet. Oberwellen durch Potenzierung zu erzeugen ist im Vergleich zum bekannten Clipping oder Gleichrichten wesentlich "sauberer". Erfindungsgemäß wird das Signal nach oder vor der Potenzierung amplitudenkorrigiert.

Die Erfindung wird nachfolgend anhand von Ausführungsbeispielen im Zusammenhang mit Blockschaltbildern weiter erläutert. Es zeigen:

Fig. 1     ein Blockschaltbild einer ersten Schaltungsanordnung nach der Erfindung mit einer Einrichtung zur Eingrenzung der unteren Grundfrequenz,

Fig. 2     ein detaillierteres Blockschaltbild zu Fig. 1,

Fig. 3     ein Blockschaltbild einer zweiten Schaltungsanordnung nach der Erfindung mit einer Einrichtung zur Potenzierung des Grundfrequenzsignales,

Fig. 4     ein detaillierteres Blockschaltbild zu Fig. 3,

Fig. 5     eine Schaltungsdetailvariante zur Schaltung von Fig. 4.

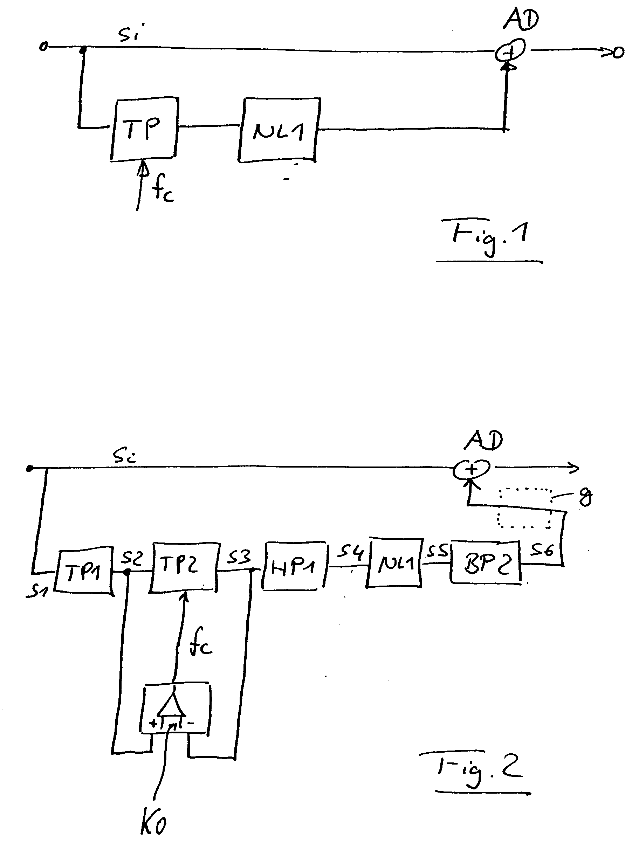

In Fig. 1 ist eine Schaltungsanordnung gezeigt, bei der ein Audioeingangssignal si einer Eingangsklemme einer Addierstufe AD zugeführt wird. Der Ausgang der Addierstufe AD ist z. B. mit einem Lautsprecher oder einem diesen vorgeschalteten Verstärker verbunden. Das Signal si wird auch über eine Filtereinrichtung, hier ein Tiefpaßfilter TP oder einen Bandpaß einer nichtlinearen Schaltungseinheit NL1, die Oberwellen aus dem gefilterten Signal erzeugt, zugeführt. Die Filteranordnung dient zur genauen Bestimmung der dominierenden Grundfrequenz im Signal si. Die Einheit NL1 erzeugt hieraus Oberwellen und führt diese einer zweiten Eingangsklemme der Addierstufe AD zu. Wesentlich ist, daß die Eckfrequenz fc des Filters TP einstellbar ist.

In Fig. 2 ist ein etwas detaillierteres Schaltbild zu Fig. 1 gezeigt. Das Filter besteht insgesamt aus der Reihenschaltung eines ersten Tiefpaßfilters TP1, eines nachgeschalteten zweiten Tiefpaßfilters TP2 und eines nachgeschalteten Hochpaßfilters HP1. Die Signale an den jeweiligen Eingängen sind mit s1, s2 und s3 bezeichnet. Am Ausgang des Hochpaßfilters HP1 steht das Signal s4 an, das der Einheit NL1 zugeführt wird. Ausgangseitig ist die Einheit NL1 mit einem Bandpaß BP2 in Verbindung, dem das Signal s5 zugeführt wird. Das Signal am Ausgang des Bandpasses heißt s6 und wird, ggf. verstärkt um einen Faktor g an die Addierstufe AD gelegt.

Das Tiefpaßfilter TP1 hat eine feste Eckfrequenz von z. B. 200 Hz. Das Tiefpaßfilter TP2 hat eine variable Eckfrequenz fc. Das Hochpaßfilter HP1 hat z. B. eine konstante Eckfrequenz von 50 Hz oder von $k *$ fc, wobei k < 1 gewählt ist. Das Bandpaßfilter BP2 hat z. B. eine Mittenfrequenz, die proportional zu fc ist.

Die Eckfrequenz fc des Tiefpaßfilters TP2 ist z. B. dadurch einstellbar, daß ein Komparator KO, dem das Signal s2 und s3 zum Vergleichen zugeführt wird, ein Steuersignal bereitstellt, das die Eckfrequenz des Tiefpaßfilters TP2 bestimmt.

Die Funktion der Schaltungsanordnung von Fig. 2 ist wie folgt. In dem Tiefpaßfilter TP1 erfolgt eine Vorselektion der tiefen Frequenzen. Im Tiefpaßfilter TP2 erfolgt eine weitere Filterung. Die Eckfrequenz fc wird dabei so eingestellt, daß gilt:

$$s3 = q * s2, \text{ wobei } 0<q<1$$

(Anm.: "*" bezeichnet eine Multiplikation)

Mit s3 und s2 können in obiger Formel die Signalamplituden der Signale s3 und s2 oder auch deren Signalenergien bezeichnet sein.

Die Eckfrequenz fc wird also so eingestellt, daß am Ausgang des Tiefpaßfilters TP2 ein bestimmter Anteil q des Signales s2 ansteht. Dadurch können nur die tiefsten Frequenzanteile des Signales si = sl passieren. Andere störende Signalfrequenzen werden herausgefiltert.

Die Bestimmung der Eckfrequenz fc kann z. B. durch folgenden Regelalgorithmus erfolgen:

$$fc = fc + df, \text{ falls } s3<q*s2$$

$$fc = fc - df, \text{ falls } s3>q*s2.$$

df bestimmt hierbei die Konvergenzgeschwindigkeit der Regelung und ist vorteilhaft kleiner oder gleich 1 Hz gewählt.

In anderen Worten wird also der tiefe Frequenzbereich des Audiosignales si = s1 in z. B. 1 Hz-Schritten abgefragt und dabei bestimmt, bei welcher Frequenz das Signal die größte Amplitude oder Energie hat. Diese Frequenz ist dann die gesuchte Grundfrequenz, für die Oberwellen in der nichtlinearen Einheit NL1 erzeugt werden.

Das Signal s3 wird im Hochpaßfilter HP1 hochpaßgefiltert, wobei die Eckfrequenz konstant oder auch als Funktion von fc gewählt sein kann. Unerwünschte Frequenzen im Signal s5 werden durch den Bandpaß BP2 entfernt. Vorteilhaft ist hierbei die Mittenfrequenz des Bandpasses BP1 auch in Abhängigkeit der Eckfrequenz fc zu ändern.

Werden z. B. durch die Einheit NL1 hauptsächlich Signale mit der ersten Oberwelle erzeugt, d. h. die Signalfrequenz der Grundwelle verdoppelt, kann die Mittenfrequenz fbp = 2 * fc gewählt werden.

Das Signal s6 am Ausgang des Bandpasses BP2 wird vorzugsweise mit einem Faktor g verstärkt auf das Signal si in der Addierstufe Ad hinzuaddiert.

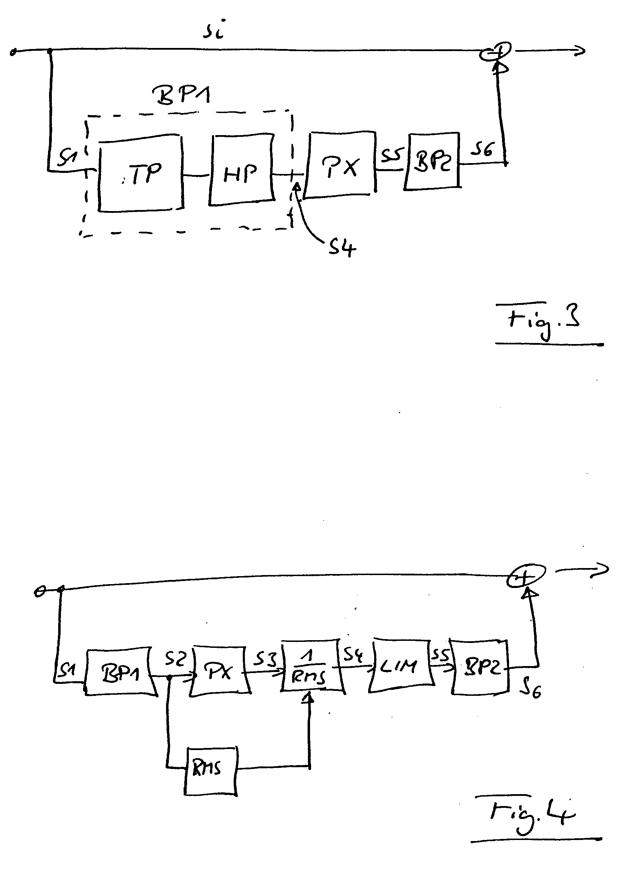

In Fig. 3 ist eine Schaltungsanordnung dargestellt, bei der in dem nicht direkt zur Addierstufe AD führenden Signalzweig eine Filteranordnung, z. B. ein Bandpaß BP1 mit Tiefpaß TP und nachgeschalteten Hochpaß HP, angeordnet ist. Am Ausgang der Filteranordnung BP1 wird ein Signal s4 bereitgestellt, das die auf beliebige Art ermittelte Grundfrequenz darstellt. Vorzugsweise ist die Filteranordnung BP1 die im Zusammenhang mit den Fig. 1 und Fig. 2 Vorgestellte.

Das Signal s4 wird in der nichtlinearen Einheit PX quadriert und somit die erste Oberwelle erzeugt. Das dabei entstehende Signal s5 gelangt an ein weiteres Filter, hier ein Bandpaßfilter BP2. Schließlich wird das Signal s6 am Ausgang des Bandpasses BP2 direkt oder mit einem Faktor g multipliziert der Addiertufe AD zugeführt. Anstelle der Quadrierung kann auch eine Potenzierung des Signals mit 3 oder 4 oder ganzzahlig höher erfolgen.

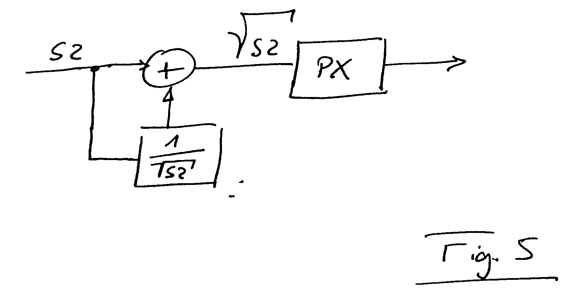

In den Fig. 4 und 5 sind verbesserte Schaltungsanordnungen zu Fig. 3 dargestellt, weil dort eine Normierung des Signals nach (Fig. 4) bzw. vor (Fig.5) der Potenzierung vorgesehen ist.

In Fig. 4 ist hierfür das Signal s2 zusätzlich einem RMS-Detektor RMS zugeführt. Dieser ist mit einer Dividierstufe 1/RMS in Verbindung, welche an den Ausgang der Einheit PX geschaltet ist und dessen Ausgangssignal s3 durch den Wert RMS dividiert. Die Dividierstufe 1/RMS ist von einem Limiter LIM gefolgt, der ausgangsseitig an einen Bandpaß BP2 geschaltet ist.

Durch Normierung mit dem RMS-Wert des Signals, das durch den Detektor RMS berechnet wird, erhält das Signal s3 wieder seine ursprüngliche Amplitude gemäß

$$s4 = (s2^2)/RMS(s2).$$

Der Detektor RMS besitzt eine Zeitkonstante tau von z. B. 0,2 sec. Da die Amplitude von s3 unter Umständen sehr viel schneller ansteigt als der RMS-Wert, der eine höhere Zeitkonstante besitzt, können im Signal s4 sehr hohe Werte auftreten. Die Werte des Signals s4 werden deshalb in dem Limiter LIM auf einen zulässigen Wert begrenzt. Die erzeugten Oberwellen werden nochmals begrenzt im Bandpaß BP2 mit der Mittenfrequenz fbp2 und dann in der Addierstufe AD dem Audiosignal si zugemischt.

Oben wurde davon ausgegangen, daß die Einheit PX das Signal s2 quadriert, also Oberwellen erster Ordnung erzeugt. Bei dieser Wahl ist die Mittenfrequenz fbp2 des zweiten Bandpasses BP2 2 mal zur Mittenfrequenz fbp1 des ersten Bandpasses zu wählen.

Ebensogut können jedoch auch Oberwellen höherer Ordnung erzeugt werden, wenn die Einheit PX hierfür geeignet ausgebildet ist. Bei einer Potenzierung um den Faktor drei müßte fbp2=fbp1*3 gewählt werden, da die Frequenz verdreifacht wurde.

Es liegt im Rahmen der Erfindung, daß mehrere der oben vorgestellten Schaltungen parallel geschaltet werden, um mehrere Oberwellen, z. B. die erste und die zweite Oberwelle, gleichzeitig zu erzeugen.

**Patentansprüche**

1. Vorrichtung zur Erzeugung von Oberwellen in einem Audiosignal mit einer Addierstufe (AD), durch welche Signale einer ersten Signalstrecke und einer zweiten Signalstrecke addierbar wird, wobei am Ausgang der Addierstufe (AD) ein oberwellenbehaftetetes Audiosignal abprüfbar und in der zweiten Signalstrecke eine Filtereinrichtung (TP) und eine nichtlineare Schaltungseinrichtung (NL) angeordnet ist,
**dadurch gekennzeichnet,** dass eine Eckfrequenz (fc) der Filtereinrichtung (TP) einstellbar ist.

2. Vorrichtung nach Anspruch 1,
**dadurch gekennzeichnet,** dass die Filtereinrichtung (TP) ein Tiefpaßfilter ist.

3. Vorrichtung nach Anspruch 1,
**dadurch gekennzeichnet,** dass dem Tiefpaßfilter (TP) ein Hochpaß (HP) vor oder nachgeschaltet ist.

4. Vorrichtung nach Anspruch 1 bis 3,
**dadurch gekennzeichnet,** dass das Tiefpaßfilter (TP) aus einer Reihenschaltung eines ersten Tiefpasses (TP1) mit fester Eckfrequenz und einem zweiten Tiefpaß (TP2) mit variabler Eckfrequenz gebildet ist.

5. Vorrichtung nach einem der Ansprüche 1 bis 4 oder nach dem Oberbegriff des Anspruchs 1,
**dadurch gekennzeichnet,** dass die nichtlineare Schaltungseinrichtung (NL) eine Potenzierstufe (PX) ist und der Potenzierstufe (PX) ein Bandpaß (BP2) nachgeschaltet ist.

6. Vorrichtung nach Anspruch 5,
**dadurch gekennzeichnet,** dass die Potenzierstufe (PX) eine Potenzierung des eingangsseitigen Signales um einen ganzzahligen Faktor größer gleich 2 durchführt.

AD

Si

TP

NL1

fc

Fig.1

AD

Si

g

TP1    S2  TP2   S3   HP1   S4   NL1  S5   BP2    S6

S1

fc

K0

Fig.2

si

BP1

S1 | TP | HP | PX | S5 | BP2 | S6

S4

Fig. 3

S1 | BP1 | S2 | PX | S3 | $\frac{1}{RMS}$ | S4 | LIM | S5 | BP2 | S6

RMS

Fig. 4

Fig. 5